(19) Europäisches Patentamt

European Patent Office

Office européen des brevets

(11) **EP 0 687 059 B1**

(12) **FASCICULE DE BREVET EUROPEEN**

(45) Date de publication et mention
de la délivrance du brevet:
**09.08.2000 Bulletin 2000/32**

(51) Int Cl.⁷: **H03D 7/16**

(21) Numéro de dépôt: **95401263.9**

(22) Date de dépôt: **31.05.1995**

(54) **Dispositif de suppression du signal image d'un signal de base transposés à une fréquence intermédiaire**

Vorrichtung zur Beseitigung der Spiegelfrequenz eines in eine Zwischenfrequenz umgesetzten Basisbandsignals

Image rejection apparatus for a base signal converted to an intermediate frequency

(84) Etats contractants désignés:
**DE GB**

(30) Priorité: **06.06.1994 FR 9406894**

(43) Date de publication de la demande:
**13.12.1995 Bulletin 1995/50**

(73) Titulaire: **FRANCE TELECOM**
**75015 Paris (FR)**

(72) Inventeur: **Fournier, Jean-Michel**
**F-38240 Meylan (FR)**

(74) Mandataire: **Casalonga, Axel**
**BUREAU D.A. CASALONGA - JOSSE**
**Morassistrasse 8**
**80469 München (DE)**

(56) Documents cités:
**EP-A- 0 243 733**     **WO-A-91/03882**
**CH-A- 658 558**     **GB-A- 2 236 225**
**US-A- 3 575 660**

- **IEEE INTERNATIONAL SOLID STATE CIRCUITS CONFERENCE, vol. 36, Février 1993 NEW YORK (US), pages 144-145, XP 000388056 M.D. MCDONALD 'A 2.5 GHz BICMOS Image-Reject Front-End'**
- **MICROWAVE JOURNAL, vol. 29, no. 10, Octobre 1986 NORWOOD (US), pages 141-149, S.E. AVERY 'Dual mixers'**

# Description

L'invention concerne la suppression ("rejection" en langue anglaise) du signal image d'un signal de base transposés à une fréquence intermédiaire.

L'invention s'applique avantageusement mais non exclusivement dans les systèmes de réception radio fréquence, en particulier aux environ de 1 à 3 GHz, intégrés et utilisant une technologie silicium bipolaire ou BiCMOS, c'est-à-dire à base de composants semi-conducteurs tels que des transistors bipolaires et/ou des transistors à effet de champ complémentaires, ainsi que des composants passifs résistifs ou capacitifs.

Dans le domaine de la réception radio fréquence, ou hyperfréquence, utilisant des canaux à bandes étroites, la sélectivité requiert l'utilisation d'une transposition du canal sélectionné à une fréquence intermédiaire fixe prédéterminée. On utilise pour cela un signal local dont la fréquence est choisie en fonction de la fréquence du canal sélectionné et de la .fréquence intermédiaire. Plus précisément, la fréquence du signal local est ajustée de façon à ce que le module de la différence entre la fréquence du signal de base reçu et la fréquence du signal local soit égale à la fréquence intermédiaire.

Or, l'homme du métier sait que pour chaque signal de base reçu, il existe un signal "image" ayant une fréquence qui satisfait la relation précédemment mentionnée et qui vient se superposer au signal de base.

Une solution pour supprimer le signal image du signal de base, tous deux transposés à une même fréquence intermédiaire prédéterminée, consiste à utiliser des dispositifs intégrés basés sur un traitement électronique du signal.

La solution la plus classiquement utilisée, et notamment décrite dans l'article de Mark D. McDonald, A 2,5 GHz BiCMOS image-Reject Front-End, ISSCC 93/SESSION 9/ RADIO COMMUNICATION CIRCUITS/ PAPER TP 9.4, 1993, consiste à prévoir un oscillateur local attaquant en quadrature, à travers un premier déphaseur, deux multiplieurs pour transposer le signal d'entrée reçu en deux signaux intermédiaires, ayant ladite fréquence intermédiaire, sur deux voies parallèles. Après le passage à travers un deuxième déphaseur introduisant un déphasage supplémentaire de 90°, et placé sur l'une des voies, les signaux résultants sur les deux voies sont en phase en ce qui concerne le signal utile tiré du signal de base, et en opposition de phase en ce qui concerne le signal tiré du signal image. Si les amplitudes des signaux sur les deux voies sont identiques, un sommateur permet d'éliminer l'"image" du signal.

Pour réaliser de tels déphaseurs, on choisit généralement des réseaux à composants passifs résistifs et capacitifs, facilement intégrables, et en outre bien adaptés au domaine de fréquences utilisées.

Or, ces déphaseurs sont des éléments très critiques car la suppression du signal image est très sensible au déphasage et à la différence d'amplitude que ces déphaseurs apportent entre les deux signaux présents aux entrées du sommateur. Plus précisément, dans de tels dispositifs, la différence des amplitudes des deux signaux sommés dépend du centrage fréquentiel des composants résistifs et capacitifs. Or, les variations relatives sur les valeurs de résistance et de capacité peuvent être de l'ordre de 10 à 20%. Par ailleurs, cette différence d'amplitude est également sensible à la variation de fréquence de l'oscillateur local.

En outre, il apparaît également que, en ce qui concerne le deuxième déphaseur, s'il n'apporte aucune atténuation de signal à son passage, il conduit à une imprécision du déphasage compte tenu des imprécisions des valeurs de résistance et de capacité influençant le bon centrage fréquentiel de ces composants par rapport à la fréquence intermédiaire.

En conclusion, les imprécisions, tant sur le déphasage que sur l'amplitude, provoquées par la présence des deux déphaseurs dans de tels dispositifs, conduisent à une suppression imparfaite du signal image.

US 3 575 660 décrit un dispositif de suppression de signal image comprenant un oscillateur local délivrant respectivement par l'intermédiaire de deux déphaseurs résistifs-capacitifs, deux signaux de mélange en quadrateur de phase, à deux mélangeurs. Les sorties des deux mélangeurs sont également reliés par l'intermédiaire de deux autres déphaseur résistifs-capacitifs à un circuit d'élimination du signal image.

Un tel dispositif conduit également à une suppression imparfaite du signal image, notamment en ce qui concerne les différences d'atténuations introduites par les déphaseurs.

L'invention vise à améliorer l'insensibilité de la suppression du signal image, aux dispersions technologiques des composants utilisés, notamment dans une technologie intégrée silicium bipolaire ou BiCMOS.

L'invention propose un dispositif de suppression du signal image d'un signal de base transposés à une fréquence intermédiaire prédéterminée. Selon une caractéristique générale de l'invention, ce dispositif comprend :

- un oscillateur local délivrant un signal local de fréquence choisie en fonction de la fréquence du signal de base et de la fréquence intermédiaire,
- un premier déphaseur comportant une première cellule de déphasage résistive-capacitive et une deuxième cellule de déphasage capacitive-résistive, ces deux cellules étant reliées à la sortie de l'oscillateur pour délivrer respectivement deux signaux de mélange en quadrature de phase,
- deux mélangeurs, respectivement connectés aux deux cellules de déphasage du premier déphaseur, et recevant respectivement le signal d'entrée, contenant le signal de base et le signal image, ainsi que les deux signaux de mélange pour délivrer deux signaux intermédiaires ayant ladite fréquence intermédiaire,

- un deuxième déphaseur comportant une première cellule de déphasage capacitive-résistive reliée au mélangeur connecté à la première cellule de déphasage résistive-capacitive, et une deuxième cellule de déphasage résistive-capacitive reliée au mélangeur connecté à la deuxième cellule de déphasage capacitive-résistive, le deuxième déphaseur introduisant une quadrature supplémentaire de phase entre les deux signaux intermédiaires,

- des moyens d'élimination du signal image comportant un sommateur relié aux deux sorties des deux cellules passives de déphasage du deuxième déphaseur, l'une des entrées du sommateur étant inversée.

La quadrature résultante de phase entre les deux signaux de mélange en sortie de chaque cellule de déphasage du premier déphaseur, est alors indépendante de la fréquence de l'oscillateur local. En outre, la quadrature supplémentaire de phase introduite entre les deux voies de traitement, au passage du deuxième déphaseur, est également indépendante de la fréquence intermédiaire. En d'autres termes, l'invention permet ici, par une répartition des déphaseurs sur chacune des voies, de rendre les déphasages introduits au passage des deux déphaseurs, indépendants des fréquences locale et intermédiaire et donc indépendants des imprécisions de valeurs des composants résistifs et capacitifs formant ces déphaseurs. On obtient donc ainsi une première amélioration de l'insensibilité de la suppression du signal image, aux dispersions technologiques des composants utilisés.

Il s'avère en outre avantageux qu'une cellule de déphasage résistive-capacitive soit suivie d'une cellules déphasage capacitive-résistive sur chacune des voies et inversement. Une telle répartition des cellules de déphasage permet de compenser au premier ordre les différences d'atténuation introduites par les déphaseurs. L'invention permet donc de rendre l'atténuation apportée par les déphaseurs, moins sensible au centrage fréquentiel des composants passifs par rapport aux fréquences locale et intermédiaire choisies initialement. L'invention apporte donc ici une deuxième amélioration de l'insensibilité de la suppression du signal image

Il s'avère par ailleurs également avantageux que les moyens d'élimination comportent un amplificateur à gain commandé en tension, connecté entre l'une des entrées du sommateur et la sortie de la cellule passive de déphasage correspondante du deuxième déphaseur, la commande du gain de cet amplificateur étant effectuée à partir de la tension de commande de l'oscillateur local.

L'apport d'un réglage de gain commandé en tension entre les deux entrées du sommateur permet ainsi de rattraper la variation d'amplitude des signaux de mélange, due à la variation de fréquence de l'oscillateur local. Cette variation peut être ainsi compensée en pilotant le gain différentiel du sommateur par la tension de commande de l'oscillateur local commandé en tension. En outre, la superposition d'une tension constante à la tension de commande du réglage de gain permet de rattraper la différence d'amplitude entre les deux signaux intermédiaires introduite par un décentrage de cette fréquence par rapport au deuxième déphaseur. Ceci permet de choisir a posteriori une fréquence intermédiaire optimale pour le dispositif différente de celle pour laquelle le deuxième déphaseur a été initialement centré sans détérioration de la suppression de la fréquence image. Le même principe permet de rattraper une différence de gain éventuelle des deux mélangeurs.

D'autres avantages et caractéristiques de l'invention apparaîtront à l'examen de la description détaillée d'un mode de réalisation nullement limitatif, et des dessins annexés sur lesquels:

la figure 1 illustré schématiquement un mode de réalisation du dispositif selon l'invention, et

- la figure 2 illustre plus en détail une cellule de déphasage du dispositif de la figure 1 utilisable sur des voies de traitement véhiculant des signaux différentiels.

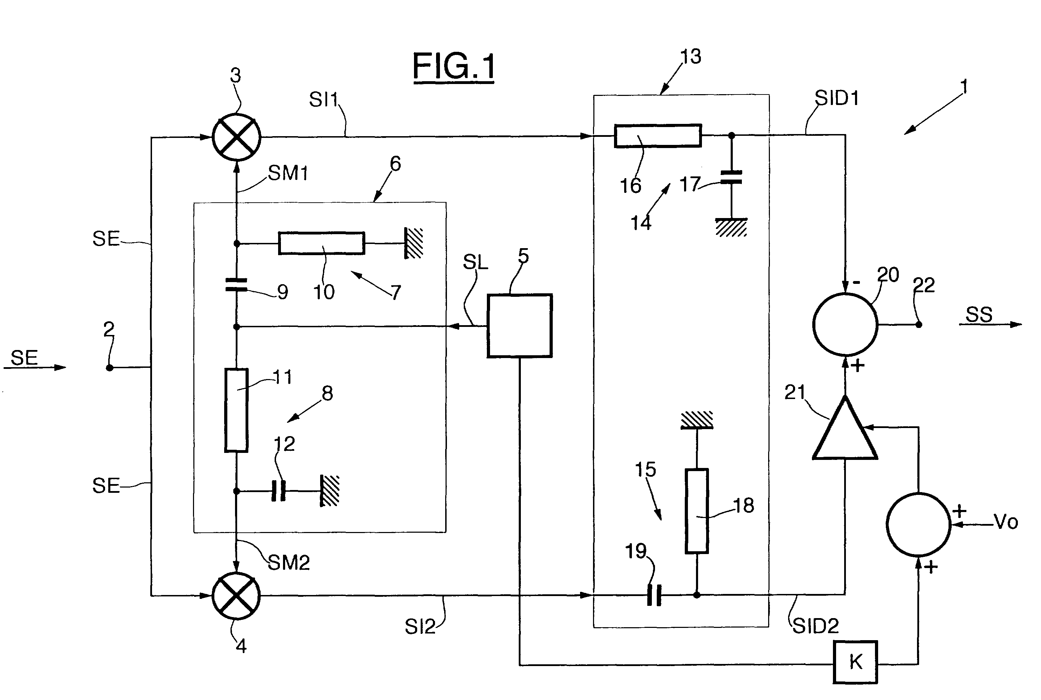

Tel qu'illustré sur la figure 1, le dispositif 1 selon l'invention, réalisable par exemple selon une technologie intégrée silicium BiCMOS, comporte une entrée de signal 2 pour recevoir un signal d'entrée SE contenant un signal de base et le signal image de ce signal de base. L'homme du métier sait que si FB désigne la fréquence du signal de base, et FI la fréquence intermédiaire du signal intermédiaire en lequel sera transposé le signal d'entrée SE, la fréquence du signal image est égale à FB+2FI.

Deux mélangeurs 3 et 4, par exemple des multiplieurs, sont connectés à l'entrée de signal 2. Ils reçoivent par ailleurs respectivement, également en entrée, deux signaux de mélange SM1 et SM2 issus d'un signal local SL délivré par un oscillateur local 5 commandé en tension. La fréquence FL du signal local est ajustée de façon que FI = | FB-FL |.

Plus précisément, la sortie de l'oscillateur local 5 est reliée à l'entrée d'un premier déphaseur 6 comportant deux cellules passives de déphasage 7 et 8.

La cellule de déphasage 7, est une cellule capacitive-résistive en ce sens qu'elle comporte une capaciteé 9 connectée en série entre la sortie de l'oscillateur 5 et l'entrée du multiplieur correspondant 3, ainsi qu'une résistance 10 connectée entre la masse et la borne de la capacité 9 reliée à l'entrée du mélangeur 3.

La cellule de déphasage 8 est une cellule résistive-capacitive en ce sens qu'elle comporte une résistance 11 connecté en série entre la sortie de l'oscillateur 5 et l'entrée de l'autre mélangeur 4, ainsi qu'une capacité 12 connectée entre la masse et la borne de la résistance 11 reliée à l'entrée du mélange 4.

Les sorties des deux mélangeurs 3 et 4 sont reliées aux deux entrées d'un sommateur 20 (dont l'une d'entre elles est inversée) par l'intermédiaire d'un deuxième déphaseur 13 comportant également deux cellules passives de déphasage à composants résistif et capacitif, réparties sur les deux voies de traitement.

Plus précisémment, la cellule passive de déphasage 14 est une cellule résistive capacitive en ce sens qu'elle comporte une résistance 16 connectée en série entre la sortie du mélangeur correspondant 3 et le sommateur 20 ainsi qu'une capacité 17 connectée entre la masse et la borne de la résistance 16 reliée au sommateur.

Par contre, la cellule passive de déphasage 15, située sur l'autre voie, est une cellule capacitive-résistive en ce sens que c'est cette fois-ci la capacité 19 qui est connectée en série entre la sortie du mélangeur et le sommateur tandis que c'est la résistance 18 qui est connectée entre la masse et la borne de la capacité reliée au sommateur.

La constitution des cellules passives de déphasage à partir uniquement de résistances et de capacités convient pour des applications radiofréquence jusqu'à quelques Gigahertz. Cependant, pour des fréquences plus élevées, notamment dans le domaine des hyperfréquences, il convient d'introduire une modélisation plus fine des composants (introduction d'inductances et phénomènes de propagation). Cependant le principe de fonctionnement qui va être décrit plus en détail ci-après reste inchangé malgré l'adjonction de ces éventuels autres composants passifs.

Dans le mode de réalisation illustré sur la figure 1, l'une des entrées du sommateur est inversée. Il s'agit dans l'exemple illustré de celle connectée à la sortie de la cellule de déphasage 14. Bien entendu, il aurait pu s'agir de l'autre entrée. En outre, cette inversion a été représentée schématiquement sur la figure 1 par le signe - .Elle peut être réalisée matériellement en plaçant un inverseur entre la sortie de la cellule de déphasage 14 et un additionneur formant le sommateur. On pourrait également prévoir de disposer directement un soustracteur à la place du sommateur.

La sortie du sommateur 20 est reliée à la sortie de signal 22 du dispositif délivrant un signal de sortie SS débarrassé, au moins quasiment, du signal image.

En outre, le mode de réalisation illustré ici prévoit l'incorporation sur l'une des voies, ici la voie contenant le mélangeur 4, d'un amplificateur 21 à gain commandé en tension. Celui-ci est connecté entre la sortie de la cellule passive de déphasage correspondante et l'entrée correspondante du sommateur. Son entrée de commande de gain reçoit par ailleurs, par l'intermédiaire d'un gain fixe ajusté K, la tension de commande de l'oscillateur local 5.

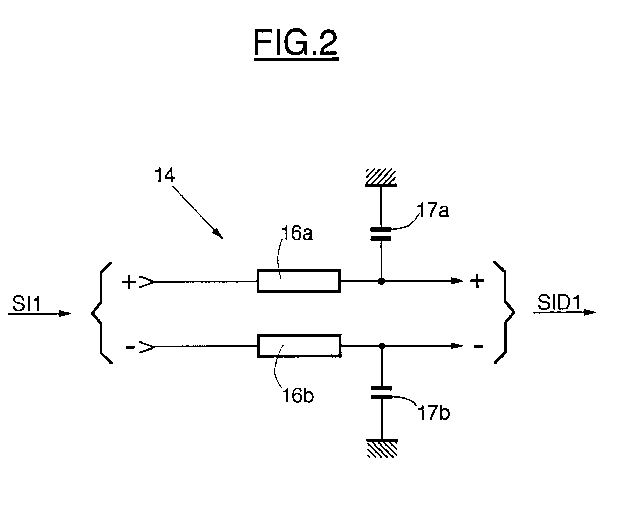

Le mode de réalisation de la figure 1 est représenté de façon très schématique. L'homme du métier saura aisément le réaliser à partir de cette illustration. Ainsi par exemple, lorsque les voies de traitement véhiculent habituellement des signaux différentiels, les entrées des mélangeurs, du sommateur et de l'amplificateur à gain commandé seront en fait des paires d'entrées différentielles. Dans ce cas, l'inversion sur l'une des entrées du sommateur (figure 1) est réalisée simplement par la permutation des deux lignes formant la paire différentielle sur l'entrée correspondante. Par ailleurs, comme illustré sur la figure 2, une cellule résistive-capacitive, telle que la cellule 14 sera en fait constituée de deux résistances 16a et 16b respectivement connectées en série sur les deux lignes différentielles + et -, ainsi que deux capacités 17a et 17b respectivement connectées entre la masse et chacune des lignes + et -.

Le fonctionnement du dispositif selon l'invention va maintenant être décrit.

Après passage dans la cellule de déphasage 7 du premier déphaseur 6, le signal de mélange SM1 est déphasé de $\pi/2-\varphi1$ par rapport au signal local SL, tandis que le signal de mélange SM2, après passage dans la cellule de déphasage 8, est déphasé de $-\varphi1$ par rapport au signal local SL. L'homme du métier sait que $\varphi1 = \text{Arctg}(R.C.2.\pi.FL)$ où Arctg désigne la fonction Arctangente, FL la fréquence du signal local, R la valeur des résistances 10 et 11 et C la valeur des capacités 9 et 12. Le déphasage entre les deux signaux de mélange SM1 et SM2 est donc égal à $\pi/2$ et est indépendant de la valeur de la fréquence FL du signal local SL et de la valeur des résistances et capacités des cellules de déphasage.

Par contre, le rapport des modules |SM1| / |SM2| des signaux SM1 et SM2, représentatif de la différence d'amplitude des deux signaux SM1 et SM2 ou de l'atténuation engendrée par le déphaseur 6, est égal au produit $R.C.2.\pi.FL$, et est donc dépendant de la valeur de la fréquence locale FL et des valeurs des composants. Par ailleurs, des signaux se présentant à l'entrée du deuxième déphaseur 13 et ayant entre eux un déphasage donné, ressortent du déphaseur 13 avec un déphasage mutuel supplémentaire de $\pi/2$. Le deuxième déphaseur 13 introduit donc une quadrature supplémentaire de phase entre les deux voies de traitement. Cependant, comme pour le premier déphaseur 6 ce déphasage supplémentaire est indépendant de la fréquence des signaux (ici la fréquence intermédiaire) et des valeurs des résistances et capacités.

Ainsi, le fait de disposer au sein de chaque déphaseur 6 et 13, une cellule de déphasage sur chacune des voies conduit à rendre le déphasage finalement obtenu en sortie du deuxième déphaseur, indépendant du centrage des différents composants par rapport aux fréquences respectives ou, dans d'autres termes, des imprécisions sur les valeurs et résistances et capacités employées.

Cet avantage est obtenu dès que l'on répartit la structure de chacun des déphaseurs sur chacune des voies de traitement, et ce indépendamment du fait que sur chaque voie de traitement, on dispose soit une cellule résistive-capacitive suivie d'une cellule capacitive-résistive ou inversement, soit deux cellules de même type.

Cependant, puisque chaque déphaseur pris individuellement, engendre une atténuation de signaux, qui dépend des valeurs des fréquences respectives et des valeurs des résistances et capacités utilisées, il s'avère préférable de prévoir que, sur chaque voie de traitement, une cellule capacitive-résistive (par exemple la cellule 7) soit suivie d'une cellule résistive capacitive (par exemple la cellule 14) et inversement (cellules 8 et 15). En effet, cette combinaison de moyens permet d'obtenir une atténuation |SID1|/|SID2| des signaux SID1 et SID2 présents en entrée du sommateur, égale au rapport (R.C.FL)/(R'.C'.FI), où R et C désignent les valeurs des résistances et capacités du premier déphaseur et R', C' les valeurs des résistances et capacités du deuxième déphaseur. Bien entendu, on choisira les valeurs théoriques R, C, R', C' des résistances et des capacités, compte tenu des valeurs choisies pour FL et FI, de façon à obtenir un rapport égal à 1 c'est-à-dire une atténuation nulle.

En outre, cette atténuation est quasiment indépendante au premier ordre des imprécisions sur les valeurs des résistances et des capacités car, d'une part,

$$\frac{\Delta SID1}{SID1} - \frac{\Delta SID2}{SID2} = \frac{\Delta R}{R} - \frac{\Delta R'}{R'} + \frac{\Delta C}{C} - \frac{\Delta C'}{C'},$$

et d'autre part les variations relatives des résistances sont sensiblement identiques et de même que les variations relatives des capacités.

En combinaison avec cet agencement particulier des cellules de déphasage, l'une des entrées du sommateur 20 doit être inversée. En effet, en sortie du mélangeur 3, le signal intermédiaire SI1 ayant la fréquence intermédiaire FI, se compose en fait du signal de base transposé ayant une phase égale à $-\pi/2+\varphi 1$ et du signal image transposé ayant une phase égale à $-\varphi 1$.

Le signal intermédiaire SI2 se compose également du signal de base transposé ayant une phase égale à $\varphi 1$ et du signal image transposée ayant une phase égale à $-\varphi 1$.

En sortie du deuxième déphaseur 13, le signal SID1 se compose d'un signal utile ayant une phase égale à $-\pi/2+ \varphi 1-\varphi 2$ et d'un signal image ayant une phase égale $\pi/2-\varphi 1-\varphi 2$, tandis que le signal SID2 se compose du signal utile ayant une phase égale à $\varphi 1+\pi/2-\varphi 2$ et du signal image ayant une phase égale à $-\varphi 1+\pi/2-\varphi 2$.

On remarque que les deux signaux image délivrés en sortie du deuxième déphaseur sont en phase tandis que les deux signaux utiles sont en opposition de phase, ce qui nécessite donc l'inversion d'une des entrées du sommateur.

Bien entendu, dans le cas où le deuxième déphaseur 13 présenterait une structure analogue à celle du premier déphaseur 6, c'est-à-dire dans le cas où la cellule du déphasage 14 serait également une cellulecapacitive-résistive au même titre que la cellule 7 (la cellule de déphasage 15 étant alors une cellule résistive-capacitive au même tire que la cellule 8) il conviendrait de ne pas inverser l'une des entrée du sommateur.

Bien que l'agencement particulier des deux déphaseurs qui vient d'être décrit, permette de s'affranchir de manière satisfaisante des dispersions technologiques des composants, il s'avère que la différence d'amplitude des deux signaux SID1 et SID2 dépend encore de la fréquence FL de l'oscillateur local.

Aussi, afin de rattraper une telle variation d'amplitude, on ajuste le gain différentiel entre les deux entrées du sommateur 20 par la commande du gain de l'amplificateur 21, à partir de la tension de commande de l'oscillateur local 5 (à travers un gain K prédéterminé). On peut ainsi adapter la plage de variation du gain de l'amplificateur 21 à la plage de variation de la fréquence du signal local.

De plus, l'adjonction d'une tension Vo à la tension pilotant le gain de l'amplificateur 21 permet:

- de rattraper la différence d'amplitude entre les signaux SID1 et SID2 due à un réglage a posteriori de la fréquence intermédiaire indépendamment du deuxième réseau déphaseur 13, ajusté pour une fréquence intermédiaire initialement choisie, et
- de rattraper une différence de gain éventuelle des mélangeurs 3 et 4.

## Revendications

1. Dispositif de suppression du signal image d'un signal de base transposés à une fréquence intermédiaire prédéterminée, caractérisé par le fait qu'il comprend :

   - un oscillateur local (5) délivrant un signal local (SL) de fréquence choisie en fonction de la fréquence du signal de base et de la fréquence intermédiaire,
   - un premier déphaseur (6) comportant une première cellule de déphasage résistive-capacitive (8) et une deuxième cellule de déphasage capacitive-résistive (7), ces deux cellules étant reliées à la sortie de l'oscillateur (5) pour délivrer respectivement deux signaux de mélange (SM1, SM2) en quadrature de phase,
   - deux mélangeurs (3, 4), respectivement connectés aux deux cellules de déphasage (7, 8) du premier déphaseur, et recevant respectivement le signal d'entrée (SE), contenant le signal de base et le signal image, ainsi que les deux signaux de mélange (SM1, SM2) pour délivrer deux signaux intermédiaires (SI1, SI2) ayant ladite fréquence intermédiaire,
   - un deuxième déphaseur (13) comportant une première cellule de déphasage capacitive-résistive (15) reliée au mélangeur (4) connecté à la première cellule de déphasage résistive-capacitive (8), et une deuxième cellule de déphasage résistive-capacitive (14) reliée au mélangeur (3) connecté à la deuxième cellule de déphasage capacitive-résistive (7), le deuxième déphaseur (13) introduisant une quadrature supplémentaire de phase entre les deux signaux intermédiaires (SI1, SI2),

- des moyens d'élimination (20, 21) du signal image comportant un sommateur (20) relié aux deux sorties des deux cellules passives de déphasage (14, 15) du deuxième déphaseur (13), l'une des entrées du sommateur (20) étant inversée (-).

2. Dispositif selon la revendication 1, caractérisé par le fait qu'il est réalisé en technologie intégrée.

3. Dispositif selon la revendication 1 ou 2, caractérisé par le fait que les moyens d'élimination comportent un amplificateur à gain commandé en tension (21), connecté entré l'une des entrées du sommateur (20) et la sortie de la cellule passive de déphasage correspondante (15) du deuxième déphaseur (13), et par le fait que la commande du gain est effectuée à partir de la tension de commande de l'oscillateur local (5).

4. Dispositif selon la revendication 3, caractérisé par le fait que la commande du gain de l'amplificateur (21) est effectuée à partir de la tension de commande de l'oscillateur local (5) et d'une tension externe choisie (Vo).

**Patentansprüche**

1. Vorrichtung zur Beseitigung der Spiegelfrequenz eines in eine vorbestimmte Zwischenfrequenz umgesetzten Basisbandsignals, dadurch gekennzeichnet, daß sie aufweist:

- einen lokalen Oszillator (5), der ein lokales Signal (SL) mit einer Frequenz liefert, die in Abhängigkeit von der Frequenz des Basisbandsignals und der Zwischenfrequenz gewählt wird,

- einen ersten Phasenschieber (6), der eine erste resistiv-kapazitive Phasenverschiebungszelle (8) und eine zweite kapazitiv-resistive Phasenverschiebungszelle (7) umfaßt, wobei diese beiden Zellen mit dem Ausgang des Oszillators (5) verbunden sind, um zwei Mischsignale (SM1, SM2), die um 90° phasenverschoben sind, zu liefern,

- zwei Mischer (3, 4), die jeweils an zwei Phasenverschiebungszellen (7, 8) des ersten Phasenschiebers angeschlossen sind und das Eingangssignal (SE), das das Basisbandsignal und das Spiegelsignal umfaßt, sowie die beiden Mischsignale (SM1, SM2) empfängt, um zwei Zwischensignale (SI1, SI2) zu liefern, die die Zwischenfrequenz aufweisen,

- einen zweiten Phasenschieber (13), der eine erste kapazitiv-resistive Phasenverschiebungszelle (15), die mit dem Mischer (4) verbunden ist, der an die erste kapazitiv-resistive Phasenverschiebungszelle (8) angeschlossen ist, und eine zweite resistiv-kapazitive Phasenverschiebungszelle (14) umfaßt, die mit dem Mischer (3) verbunden ist, der an die zweite kapazitiv-resistive Phasenverschiebungszelle (7) angeschlossen ist, wobei der zweite Phasenschieber (13) eine zusätzliche Phasenverschiebung um 90° zwischen den beiden Zwischensignalen (SI1, SI2) bewirkt,

- Mittel zur Beseitigung (20, 21) des Spiegelsignals, bestehend aus einem Summator (20), der an die beiden Ausgänge der beiden passiven Phasenverschiebungszellen (14, 15) des zweiten Phasenschiebers (13) angeschlossen ist, wobei einer der Eingänge des Summators (20) umgekehrt (-) ist.

2. Vorrichtung nach Anspruch 1, dadurch gekennzeichnet, daß sie in integrierter Technologie hergestellt ist.

3. Vorrichtung nach Anspruch 1 oder 2, dadurch gekennzeichnet, daß die Beseitigungsmittel einen offenen spannungsgesteuerten Verstärker (21) umfassen, der zwischen einem der Eingänge des Summators (20) und dem Ausgang der entsprechenden passiven Phasenverschiebungszelle (15) des zweiten Phasenschiebers (13) angeschlossen ist, und daß die Verstärkungssteuerung ausgehend von der Steuerspannung des lokalen Oszillators (5) erfolgt.

4. Vorrichtung nach Anspruch 3, dadurch gekennzeichnet, daß die Verstärkungssteuerung des Verstärkers (21) auf Basis der Steuerspannung des lokalen Oszillators (5) und einer äußeren gewählten Spannung (Vo) erfolgt.

**Claims**

1. Device for rejecting the image signal of a signal converted to a predetermined intermediate frequency, characterized in that it comprises:

- a local oscillator (5) supplying a local signal (SL) at a frequency chosen according to the frequency of the base signal and the intermediate frequency,

- a first phase-shifter (6) comprising a first resistive/capacitive phase-shifting cell (8) and a second capacitive/resistive phase-shifting cell (7), these two cells being linked to the output of the oscillator (5) so as to deliver respectively two phase-quadrature mixing signals (SM1, SM2),
- two mixers (3, 4), respectively connected to the two phase-shifting cells (7, 8) of the first phase-shifter, and respectively receiving the input signal (SE), containing the base signal and the image signal, as well as the two mixing signals (SM1, SM2) so as to deliver two intermediate signals (SI1, SI2) having the said intermediate frequency,
- a second phase-shifter (13) comprising a first capacitive/resistive phase-shifting cell (15) linked to the mixer (4) connected to the first resistive/capacitive phase-shifting cell (8), and a second resistive/capacitive phase-shifting cell (14) linked to the mixer (3) connected to the second capacitive/resistive phase-shifting cell (7), the second phase-shifter (13) introducing an additional phase quadrature between the two intermediate signals (SI1, SI2),
- means (20, 21) for eliminating the image signal comprising a summing device (20) linked to the two outputs of the two passive phase-shifting cells (14, 15) of the second phase-shifter (13), one of the inputs of the summing device (20) being inverted (-).

2. Device according to Claim 1, characterized in that it is made using integrated technology.

3. Device according to Claim 1 or 2, characterized in that the elimination means include a voltage-controlled gain amplifier (21) connected between one input of the summing device (20) and the output of the corresponding passive phase-shifter cell (15) of the second phase-shifter (13), and in that the gain is controlled by the control voltage of the local oscillator (5).

4. Device according to Claim 3, characterized in that the gain of the amplifier (21) is controlled by the control voltage of the local oscillator (5) and a selected external voltage (Vo).

FIG.1

# FIG.2